# EUROPEAN PATENT APPLICATION

(11) **EP 1 195 805 A2**
(43) Date of publication of application: **10.04.2002**
(21) Application number: 01302583.8
(22) Date of filing: 20.03.2001
(51) Int. Cl.: H01L 21/48, H01L 23/373

(54) **Heat radiation substrate and semiconductor module**

(30) Priority: 05.10.2000 JP 2000306666
(71) Applicant: Sanyo Electric Co., Ltd., Moriguchi-shi, Osaka (JP)
(72) Inventor: Sakamoto, Noriaki, Yamada-gun, Gunma (JP); Kobayashi, Yoshiyuki, Oura-gun, Gunma (JP); Sakamoto, Junji, Ota-shi, Gunma (JP); Okada, Yukio, Kiryu-shi, Gunma (JP); Igarashi, Yusuke, Isesaki-shi, Gunma (JP); Maehara, Eiju, Kiryu-shi, Gunma (JP); Takahashi, Kouji, Sawa-gun, Gunma (JP)
(74) Representative: Nicholls, Michael John

(57) **Abstract**

The FCA to which the read/write amplifier IC is adhered is mounted in the hard disk. The first metal film formed by Cu plating is formed on the second supporting member 13 made of Al, and the metal body 15 exposed on the back surface of the semiconductor device 10 is adhered.

## Description

### BACKGROUND OF THE INVENTION

The present invention relates to a semiconductor device and a semiconductor module and, more particularly, a structure that is able to radiate excellently the heat from the semiconductor device.

In recent years, application of the semiconductor device to the mobile device and the small and high density packaging device makes progress, and thus not only the reduction in size and weight but also the good radiating characteristic is requested. Also, the semiconductor device is mounted onto various substrates, and the semiconductor module containing the substrate is mounted in various apparatus . As the substrate, there are the ceramic substrate, the printed circuit board, the flexible sheet, the metal substrate, the glass substrate, etc. Here, as the semiconductor module mounted onto the flexible sheet, an example will be explained hereunder.

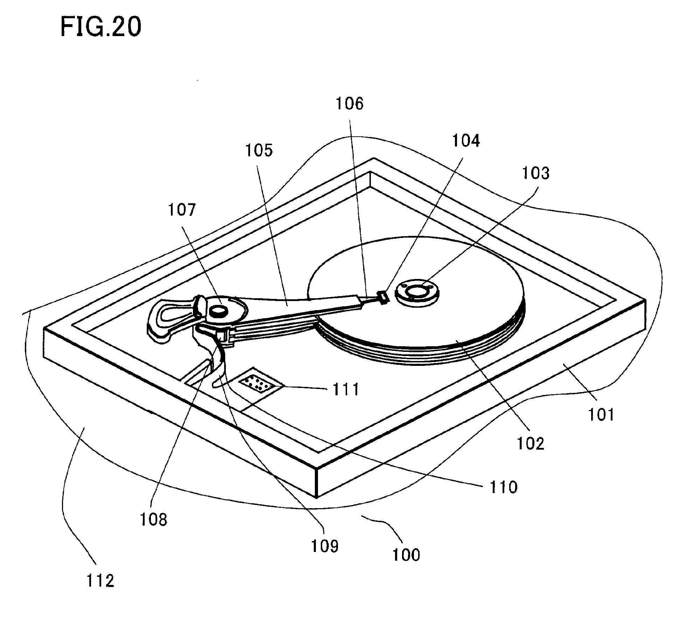

A hard disk 100 into which the semiconductor module employing the flexible sheet is mounted is shown in FIG.20. For example, this hard disk 100 is described in detail in Nikkei Electronics, 1997, June 16 (No.691), p92-.

This hard disk 100 is packaged into a casing 101 formed of metal, and plural sheet of recording disks 102 are fitted integrally to a spindle motor 103. A magnetic head 104 is arranged over a surface of the recording disk 102 via a minute clearance respectively. This magnetic head 104 is fitted to a top end of a suspension 106 that is fixed to the top of an arm 105. Then, an integral structure consisting of the magnetic heads 104, the suspension 106, and the arm 105 is fitted to an actuator 107.

The recording disks 102 must be connected electrically to a read/write amplifier IC 108 to execute the writing/ reading via the magnetic heads 104. Thus, a semiconductor module 110 in which the read/write amplifier IC 108 is mounted onto a flexible sheet 109 is employed. Wirings provided on the flexible sheet 109 are finally connected electrically the magnetic heads 104. The semiconductor module 110 is called the flexible circuit assembly and is normally abbreviated to FCA.

A connector 111 fitted onto the semiconductor module 110 is exposed from a back surface of the casing 101. This connector (male or female type) 111 is connected to another connector (female or male type) fitted to a main board 112. Also, wirings are provided on the main board 112, and also a driving IC for the spindle motor 103, a buffer memory, other driving ICs, e.g., ASIC (Application Specific Integrated Circuit), etc. are mounted.

For example, the recording disk 102 is rotated by the spindle motor 103 at 4500 rpm, and a position of the magnetic head 104 is decided by the actuator 107. Since this rotating mechanism is tightly sealed by a lid provided to the casing 101, the heat is filled inevitably in the casing 101 and thus the temperature of the read/write amplifier IC 108 is increased. Therefore, the read/write amplifier IC 108 is positioned on the actuator 107, the casing 101, or the like, that has excellent thermal conduction. Also, the rotation of the spindle motor 103 tends to increase such as 5400, 7200, 10000 rpm, and thus this heat radiation becomes important more and more.

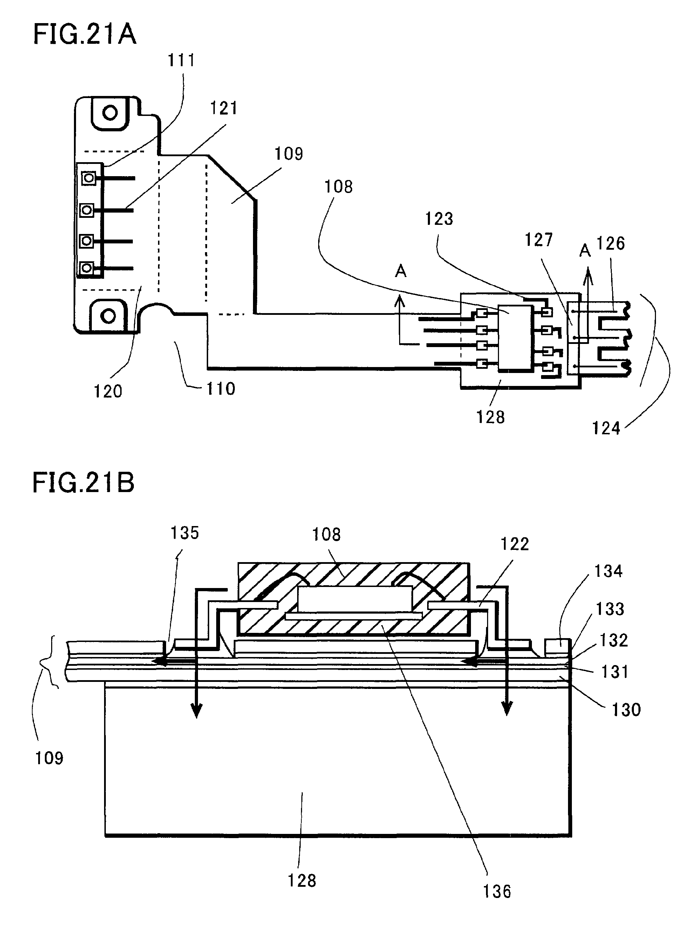

In order to explain the above semiconductor module (FCA) 110 further more, a structure of the semiconductor module is shown in FIGS.21A and 21B. FIG.21A is a plan view and FIG.21B is a sectional view in which the read/write amplifier IC 108 provided to the top portion is cut out along an A-A line. Since this FCA 110 is folded and then fitted into a part of the casing 101, a first flexible sheet 109 having' a flat shape that can be easily folded is employed.

The connector 111 is fitted to the left end of the FCA 110 to act as a first connector portion. First wirings 121 electrically connected to the connector 111 are stuck to the first flexible sheet 109 and then extended to the right end. Then, the first wirings 121 are electrically connected to the read/write amplifier IC 108. Also, leads 122 of the amplifier IC 108 connected to the magnetic heads 104 are connected to second wirings 123. The second wirings 123 are electrically connected to third wirings 126 on the second flexible sheet 124 provided over the arm 105 and the suspension 106. That is, the right end of the first flexible sheet 109 constitutes a second connecting portion 127, and is connected to the second flexible sheet 124 there. The first flexible sheet 109 and the second flexible sheet 124 may be integrally formed. In this case, the second wirings 123 and the third wirings 126 are integrally provided.

A supporting member 128 is provided on a back surface of the first flexible sheet 109 on which the read/write amplifier IC 108 is provided. The ceramic substrate or the Al (aluminum) substrate is employed as this supporting member 128. The heat generated by the read/write amplifier IC 108 can be discharged since the metals exposed in the casing' 101 is thermally coupled with the outside via the supporting member 128.

Then, a connection structure of the read/write amplifier IC 108 and the first flexible sheet 109 will be explained with reference to FIG.21B hereunder.

This first flexible sheet 109 is formed by laminating a first polyimide sheet 130 (referred to as a "first PI sheet" hereinafter), a first adhering layer 131, a conductive pattern 132, a second adhering layer 133, and a second polyimide sheet 134 (referred to as a "second PI sheet" hereinafter) from the bottom. The conductive pattern 132 is sandwiched between the first PI sheet 130 and the second PI sheet 134.

Also, in order to connect the read/write amplifier IC 108, an opening portion 135 is formed by removing the second PI sheet 134 and the second adhering layer 133 from a desired area to expose the conductive pattern 132. Then, as shown in FIG.21B, the read/write amplifier IC 108 is electrically connected via the leads 122.

In FIG.21B, the heat is emitted from the semiconductor device being packaged with an insulating resin 136 to the' outside via the heat radiation path indicated by arrows. More particularly, the semiconductor device in the prior art has such a structure that, since an insulating resin 136 acts as a thermal resistance, the heat generated from the read/write amplifier IC 108 cannot be effectively radiated to the outside in total.

Then, the hard disk will be explained hereunder. The transfer rate of the hard disk in reading/writing needs the frequency of 500 MHz to 1 GHz, or more so as to increase the reading/writing speed of the read/write amplifier IC 108. Therefore, the wiring path on the flexible sheet connected to the read/write amplifier IC 108 must be reduced and also the increase in the temperature of the read/write amplifier IC 108 must be prevented.

In particular, since the recording disks 102 are rotated at a high speed and are installed in a space of the casing 101 tightly sealed by the lid, the temperature in the casing 101 is increased up to about 70 to 80 degree. In contrast, the allowable operating temperature of the normal IC is about 125°C, and the temperature increase of about 45°C from the internal temperature of 80°C can be accepted for the read/write amplifier IC 108. However, as shown in FIG.21B, if the thermal resistance of the semiconductor device per' se or the thermal resistance of the FCA is large, the read/write amplifier IC 108 exceeds immediately the allowable operating temperature and cannot exhibit its essential ability. As a result, the semiconductor device or FCA having the excellent radiation characteristic is requested.

In addition, there is such a problem that, since the operating frequency is further increased in the future, the temperature increase of the read/write amplifier IC 108 itself is brought about by the heat generated by the operating process. Although the target operating frequency can be achieved in the normal temperature, the operating frequency must be lowered because of its temperature increase in the inside of the hard disk.

As described above, with the increase of the operating frequency in the future, the better radiation characteristic is required for the semiconductor device or the semiconductor module (FCA).

In contrast, the actuator 107 itself, or the arm 105 fitted to the actuator 107, the suspension 106, and the magnetic head 104 must be reduced in weight to reduce their moment of inertia. Especially, as shown in FIG.20, in case the read/write amplifier IC 108 is mounted on the surface' of the actuator 107, the reduction in weight of the IC 108 and the FCA 110 is also requested.

### SUMMARY OF THE INVENTION

The present invention has been made in view of the above subjects, and can overcome these subjects by satisfying following respects. First, there is provided a radiation substrate having a first surface and a second surface, both opposed to each other, and containing Al as a major component, wherein a first metal film containing Cu, Ag, or Au as major material is formed as an uppermost layer on the first surface.

Al is light and excellent in the thermal conduction, and an oxide film formed on a surface is thin and dense. If this dense oxide film is formed once, the growth of the oxide film is almost stopped. That is, in the above precision equipment such that the magnetic head and the recording disk in which the very narrow clearance like 20 to 30 nm (nano meter) should be maintained, an amount of particles generated from the oxide film is increased to cause the malfunction as the oxide film is grown much more in the equipment . However, the growth of the oxide film is small in the substrate employing Al as major material, the generation of the particles is small correspondingly and thus the damage of the malfunction of the recording disk can be reduced.

In contrast, Al and the oxide formed on the surface of Al have no wettability with conductive adhering material (brazing solder such as solder, etc., conductive paste such as Ag, Au, etc.). However, a first metal film using Cu, Ag, Sn, Ni, or Au as major material can be formed on the surface of Al. Therefore, if this first metal film is formed on an Al radiation substrate, a metal body (e.g., island or radiation electrode) exposed from the back surface of the semiconductor device can be thermally coupled with the radiation substrate 13 via the conductive adhering material. As a result, the Al substrate can be caused to operate as the radiation substrate 13 that hardly generates the particles and has excellent thermal conductivity.

Second, the first metal film consists of a plating film.

As described later, the first metal film can be formed by plating and the radiation substrate having the small thermal resistance can be implemented.

Third, a metal body provided on a back surface of a semiconductor device is adhered by brazing solder, conductive paste, or adhering material having excellent thermal conductivity.

Fourth, the semiconductor device is mounted to be connected electrically to an electronic equipment, and the second surface is worked such that it can be connected to a constituent element made of metal in the electronic equipment via surface contact.

The Al substrate can be easily worked and thus can come into contact with the inside of the electronic equipment via surface contact, and can function as the good radiation substrate.

Fifth, there is provided a semiconductor module comprising a semiconductor device in which a face up semiconductor element is sealed integrally by insulating resin and also pads connected electrically to bonding electrodes of the semiconductor element and an island positioned on a back surface of the semiconductor element are exposed from the back surface; and a radiation substrate having a first surface and a second surface, both opposed to each other, and containing Al as a major component; wherein a first metal film containing Cu, Ag, Sn, Ni, or Au as major material and formed by plating is formed as an uppermost layer on the first surface, and the first metal film and the island are adhered together by brazing solder, conductive paste, or adhering material having excellent thermal conductivity.

For example, the island and the radiation substrate can be adhered together via the brazing solder, and the heat generated from the semiconductor element can be discharged via the radiation substrate.

Sixth, a metal film containing Cu as a major component is adhered between the first metal film and the island.

If the metal plate having a predetermined thickness is provided, the back surface of this metal plate can be brought into contact with the radiation substrate or the first metal film.

Seventh, the island and the metal plate are formed integrally by the etching process.

The thickness of the metal plate is very thin and thus the metal plate is inferior in handling. However, since the metal plate can be formed integrally with the island by etching, its handling property can be improved. In addition, the thickness of the metal plate can be simply adjusted and every semiconductor module can adjusted such that the metal plate can be simply brought into contact with the radiation substrate.

Eighth, a back surface of the semiconductor element is adhered to the metal plate.

Ninth, back surfaces of the pads and a back surface of the island are arranged substantially on a same planar surface.

Tenth, back surfaces of the pads and a back surface of the semiconductor element are arranged substantially on a same planar surface.

Eleventh, a back surface of the insulating resin is projected rather than back surfaces of the pads.

Twelfth, side surfaces of the pads and a back surface of the insulating resin extended from the side surfaces of the pads draw a same curved surface. Thirteenth, a flexible sheet having conductive patterns connected electrically to the semiconductor device is provided between the semiconductor device and the radiation substrate, and an opening portion is provided in the flexible sheet to respond to the island.

Fourteenth, there is provided a semiconductor module comprising a semiconductor device in which a face down semiconductor element is sealed integrally by insulating resin and also pads connected electrically to bonding electrodes of the semiconductor element and a radiation electrode positioned on a back surface of the semiconductor element are exposed from the back surface; and a radiation substrate having a first surface and a second surface, both opposed to each other, and containing Al as a major component; wherein a first metal film containing Cu, Ag, Sn, Ni, or Au as major material and formed by plating is formed as an uppermost layer on the first surface, and the first metal film and the radiation electrode are adhered together by brazing solder, conductive paste, or adhering material having excellent thermal conductivity.

Fifteenth, a metal film containing Cu as a major component is adhered between the first metal film and the radiation electrode.

Sixteenth, the radiation electrode and the metal plate are formed integrally by the etching process.

Seventeenth, back surfaces of the pads and a back surface of the radiation electrode are arranged substantially on' a same planar surface.

Eighteenth, a back surface of the insulating resin is projected rather than back surfaces of the pads.

Nineteenth, side surfaces of the pads and a back surface of the insulating resin extended from the side surfaces of the pads draw a same curved surface.

Twentieth, a flexible sheet having conductive patterns connected electrically to the semiconductor device is provided between the semiconductor device and the radiation substrate, and an opening portion is provided in the flexible sheet to respond to the radiation electrode.

Twenty-first, there is provided a semiconductor module comprising a semiconductor device in which a face up semiconductor element is sealed integrally by insulating resin and also leads connected electrically to bonding electrodes of the semiconductor element and an island whose back surface is positioned on a same surface level as a back surface of the leads are exposed from the back surface; and a radiation substrate having a first surface and a second surface, both opposed to each other, and containing Al as a major component; wherein a first metal film containing' Cu, Ag, Sn, Ni, or Au as major material and formed by plating is formed as an uppermost layer on the first surface, and the first metal film and the island are adhered together by brazing solder, conductive paste, or adhering material having excellent thermal conductivity.

Twenty-second, a metal film containing Cu as a major component is adhered between the first metal film and the island.

Twenty-third, a flexible sheet having conductive patterns connected electrically to the semiconductor device is provided between the semiconductor device and the radiation substrate, and an opening portion is provided in the flexible sheet to respond to the island.

Twenty-fourth, the semiconductor device is a read/ write amplifier IC for a hard disk.

Twenty-fifth, the semiconductor device is mounted to be connected electrically to an electronic equipment, and the second surface is worked such that it can be connected to a constituent element made of metal in the electronic equipment via surface contact.

### BRIEF DESCRIPTION OF THE DRAWINGS

FIGS.1A and 1B are views showing a semiconductor module of the present invention;
FIGS.2A and 2B are views showing a semiconductor device of the present invention;
FIGS.3A and 3B are views showing a semiconductor device of the present invention;
FIGS.4A to 4C are views showing a semiconductor device of the present invention;
FIG.5 is a view showing a semiconductor module of the present invention;
FIGS.6A and 6B are views showing a semiconductor device of the present invention;
FIGS.7A and 7B are views showing a semiconductor device of the present invention;
FIGS.8A to 8C are views showing a semiconductor device of the present invention;
FIG.9 is a view showing a semiconductor module of the present invention;
FIG.10 is a view showing a semiconductor device of the present invention;
FIG.11 is a view showing a semiconductor device of the present invention;
FIG.12 is a view showing a method of manufacturing a semiconductor device of the present invention;
FIG.13 is a view showing a method of manufacturing a semiconductor device of the present invention;
FIG.14 is a view showing a method of manufacturing a semiconductor device of the present invention;
FIG.15 is a view showing a method of manufacturing a semiconductor device of the present invention;
FIG.16 is a view showing a method of manufacturing a semiconductor device of the present invention;
FIG.17 is a view showing a method of manufacturing a semiconductor device of the present invention;
FIG.18 is a view showing a method of manufacturing a semiconductor device of the present invention;
FIG.19 is a view showing a method of manufacturing a semiconductor device of the present invention;
FIG.20 is a view showing a hard disk; and
FIG.21A and 21B are views showing a semiconductor module employed in FIG.20 in the prior art.

### DETAILED DESCRIPTION OF THE PREFERRED EMBODIMENTS

The present invention provides a light-weight and small-size semiconductor device having the high radiation characteristic and also provides a semiconductor module in which the semiconductor device is packaged, e.g., a semiconductor module in which the semiconductor device is adhered to a radiation substrate, and a semiconductor module in which the semiconductor device is mounted on the flexible' sheet and the radiation substrate is adhered onto a back surface of the flexible sheet (called "FCA" hereinafter), and achieves improvement in the characteristic of a precision equipment into which the semiconductor module is installed, e.g., a hard disk.

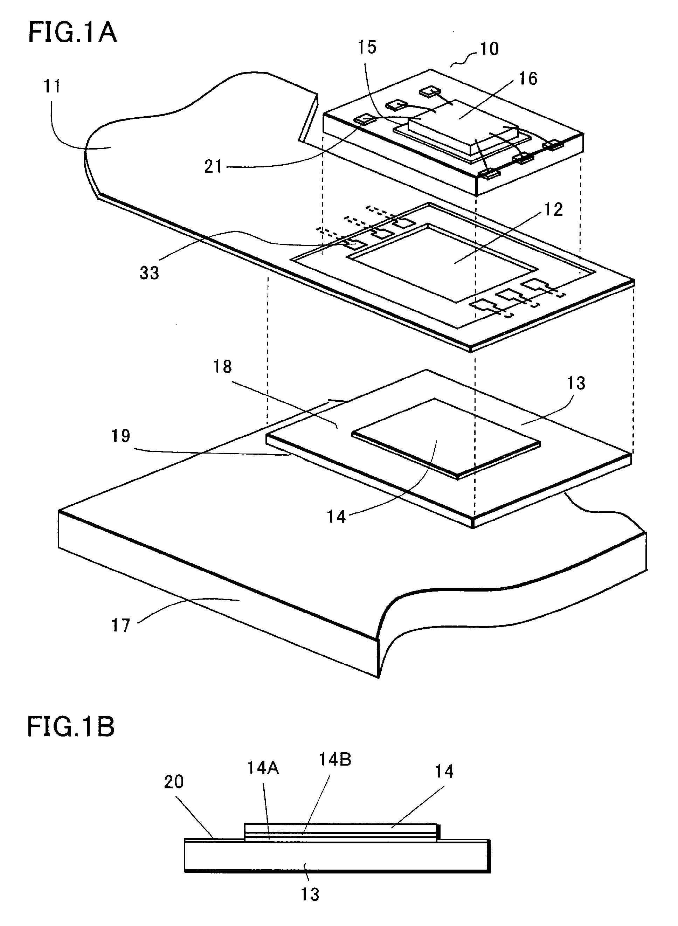

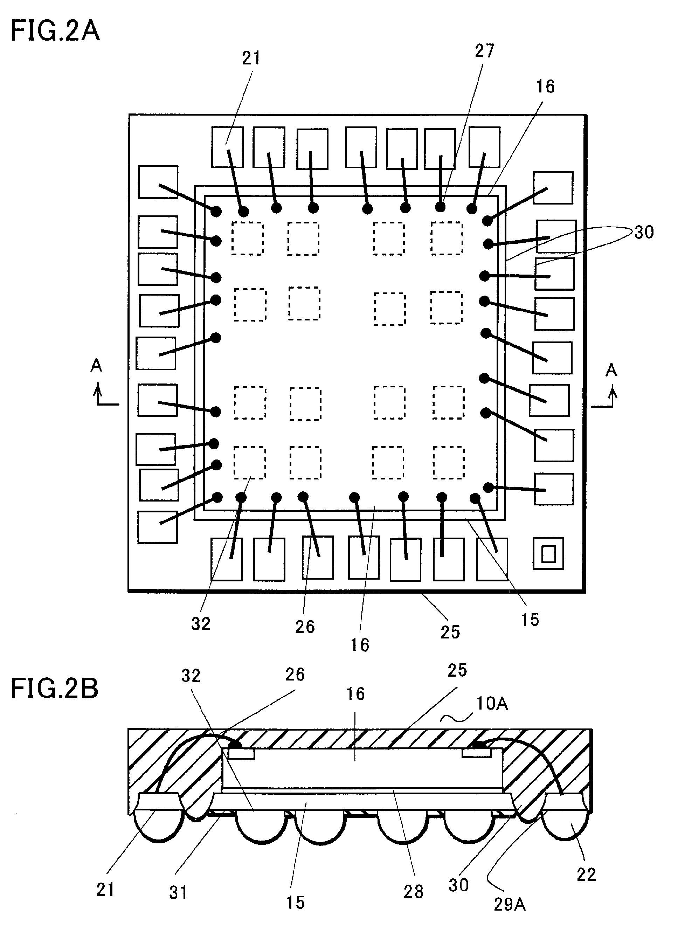

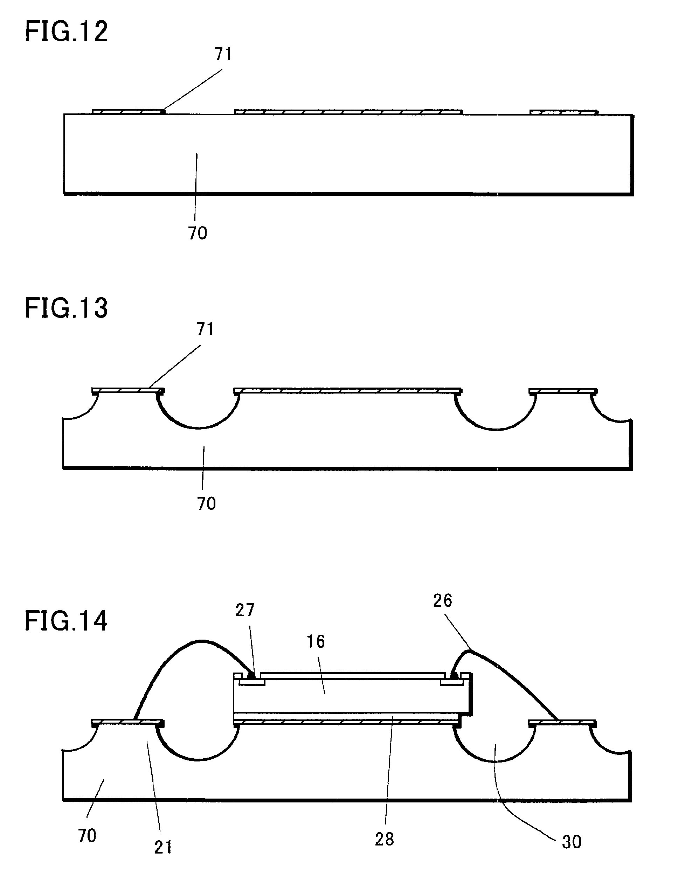

First, a hard disk 100 as an example of the equipment, into which the semiconductor module is installed, is shown in FIG.20 and the semiconductor module is shown in FIG.1, FIG.5, and FIG.9. Also, the semiconductor device that is mounted in the semiconductor module is shown in FIG.2 to FIG.4, FIG.6 to FIG.8, FIG.10 and FIG.11, and a method of manufacturing the same is shown in FIG.12 to FIG.19.

### [First embodiment explaining the equipment in which the semiconductor module is mounted]

As this equipment, the hard disk 100 explained in the prior art column and shown in FIG.20 will be explained once again.

The hard disk 100 is mounted on the main board 112 at need to install into the computer, etc. A female type (or male type) connector is fitted to this main board 112. Then, the connector is mounted into the FCA, and thus the male type (or female type) connector 111 exposed from a back surface of the casing 101 is connected to a connector on the main' board 112. Also, plural sheets of recording disks 102 as recording medium are provided in the casing 101 according to its capacity. Since the magnetic head 104 is scanned while floating over the recording disk 102 with a gap of almost 20 to 30 nm, an interval between the recording disks 102 is set to an interval that causes no trouble in such scanning. Then, the recording disks 102 are attached to the spindle motor 103 to keep this interval. The spindle motor 103 is fitted to a packaging substrate, and the connector arranged on a back surface of the packaging substrate is exposed from the back surface of the casing 101. Then, this connector is connected to the connector of the main board 112. Accordingly, an IC for driving the read/write amplifier IC 108 of the magnetic head 104, an IC for driving the spindle motor 103, an IC for driving the actuator 107, a buffer memory for temporarily saving the data, ASIC used to achieve the original drive of the maker, etc. are mounted on the main board 112. Of course, other passive elements and active elements may be mounted on the main board 112.

Then, wirings for connecting the magnetic heads 104 and the read/write amplifier IC 108 are considered as short in length as possible, and the read/write amplifier IC 108 is arranged in the actuator 107. However, since the semiconductor device of the present invention explained hereinafter is small in size and light in weight, such semiconductor device may be mounted on the arm 105 or the suspension 106 except the actuator. In this case, as shown in FIG.1A, since the back surface of the semiconductor device 10 is thermally coupled with the arm 105 or the suspension 106, the heat of the semiconductor device 10 can be emitted to the outside via the casing 101 through the suspension and the actuator.

If the semiconductor device is mounted in the actuator 107 as shown in FIG.20, all reading/writing circuits for respective channel of the read/write amplifier IC 108 are formed by a one-chip device such that a plurality of magnetic sensors can read and write. In this case, the reading/ writing circuits used exclusively for the magnetic heads 104 fitted to respective suspensions 106 may be mounted in respective suspensions or arms. In this manner, wiring distances between the magnetic heads 104 and the read/write amplifier IC 108 can be considerably shortened rather than the structure shown in FIG.20. Thus, the reduction in the impedance can be achieved accordingly and thus the improvement of the reading/writing speed can be achieved.

Since the magnetic head 104 is scanned while floating over the recording disk 102 with a gap of almost 20 to 30 nm, it is apt to be very easily damaged by particles. That is, since the high precision electronic equipment has a driving portion and a sliding portion, an Al substrate that is light in weight and hardly generates the particles is employed as a radiation substrate 13.

Al is light and excellent in the thermal conduction, and an oxide film formed on a surface is thin and dense. If this dense oxide film is formed once, the oxygen is hard to reach Al and thus the growth of the oxide film is almost stopped. Thatis, in the above precision equipment, an amount of particles generated from the oxide film is increased to cause the malfunction as the oxide film is grown much more in the equipment. However, the growth of the oxide film is small in the substrate employing Al as major material, the generation of the particles is small correspondingly and thus the damage of the malfunction of the recording disk can be reduced.

In contrast, Al and the oxide formed on the surface of Al have no affinity for conductive adhering material (brazing solder such as solder, etc., conductive paste such as Ag, Au, etc.). However, a first metal film 14 using Cu, Ag, or Au as major material can be formed on the surface of Al. Therefore, if this first metal film 14 is formed on ' an Al radiation substrate 13, a metal body 15 (e.g., island or radiation electrode) exposed from the back surface of the semiconductor device 10 can be thermally coupled with the radiation substrate 13 via the conductive adhering material. As a result, the Al substrate can be caused to operate as the radiation substrate 13 that hardly generates the particles and has excellent thermal conductivity.

### [Second embodiment explaining the radiation substrate 13]

The fact is known that, since Al oxide is formed on the surface of the radiation substrate 13 using Al as major material, the metal cannot be adhered onto the surface via the brazing solder such as solder or the conductive paste, etc. Accordingly, it is known that there is no means to adhere the Al substrate and the metal body 15 exposed from the back surface of the semiconductor device 10 except that they must be adhered to each other via the adhesive or the insulating adhesive means having good thermal conduction.

However, Al can be plated with Cu, Ag, Sn, Ni, or Au by the plating method. Thus, as shown in FIG.1B, if the plating film can be formed as the first metal film 14, the metal body 15 can be adhered onto the plating film via the brazing solder or conductive paste, (since the metal body 17 is contacting with the casing).

In addition, since insulating material is not interposed between the metal body 15 and the radiation substrate 13, the thermal resistance is very small. Thus, the heat generated from the semiconductor device 16 can be emitted from a metal body 17 constituting an electronic equipment to the outside.

Then, a method of forming the metal film made of Cu on the Al substrate will be explained hereunder.

First, the Al substrate is lightly etched with ammonium persulfate and then immersed in an acid such as sulfuric acid, etc. A concentration of the sulfuric acid is 100 ml/l, and the Al substrate is immersed at the atmospheric temperature for about one minute. In this case, l indicates liter.

Second, the oxide film and the contamination on the Al substrate is removed and then Pd 14A acting as the catalyst is arranged. Especially, since Pd 14A is deposited concentratively into one area, the process for scattering Pd 14A to arrange is executed.

Third, a Cu film 14B of about 0.2 µm thickness is generated by the electroless Cu plating method by using Pd 14A as the catalyst. Here Pd 14A acts as the nucleus and the Cu film 14B is generated on the Al substrate 13. Then, the Cu film 14B is cleaned by the sulfuric acid and then is plated with the copper sulfate by the electrolytic plating at the atmospheric temperature for 60 minutes. Accordingly, the Cu film 14B of about 20 µm thickness is grown.

According to above steps, the Cu plated film 14 is formed on the outermost surface of the Al substrate to have a film thickness of about 20 µm. Since the Cu plated film 14 can be adhered to the metal body 15 containing Cu as main material via the brazing solder, the radiation substrate 13 that has excellent thermal conduction and seldom generates the particles can be provided.

Therefore, the semiconductor device can be adhered to a first surface 18, and then a second surface 19 can be brought into contact with the constituent element 17 constituting the electronic equipment, e.g., the inside of the casing, the actuator, and the arm.

Also, the first metal film 14 is formed in one area of the Al substrate 13, and then the oxide film 20 is grown again in areas other than this one area.

Also, following methods may be employed.

First, Ni or Cu can be plated by the step called the zincate process. At first, after the Al substrate 13 is subjected to the alkaline degreasing and the alkaline etching, the zincate process is applied. This is applied to form the Zn film of about 0.1 to 0.2 µm and then form Cu or Ni by the electroless or electrolytic plating.

Second, the Al substrate 13 is subjected to the alkaline degreasing and the alkaline etching, then Ni is formed the electroless plating, and then Au is plated. In this manner, if Cu or Au is not directly plated on the Al substrate but Cu or Au is formed after a very thin film (Zn, Pd, etc.) is formed on the Al substrate, a film to which soldering is applicable can be formed on the radiation substrate. In addition, since all films are excellent in thermal conduction, such radiation substrate has the very excellent radiation characteristic.

### [Third embodiment explaining the semiconductor device]

The semiconductor device 10 shown in FIG.1A is the face-down semiconductor device 10, and its concrete structures are shown in FIG.2 to Fig.4.

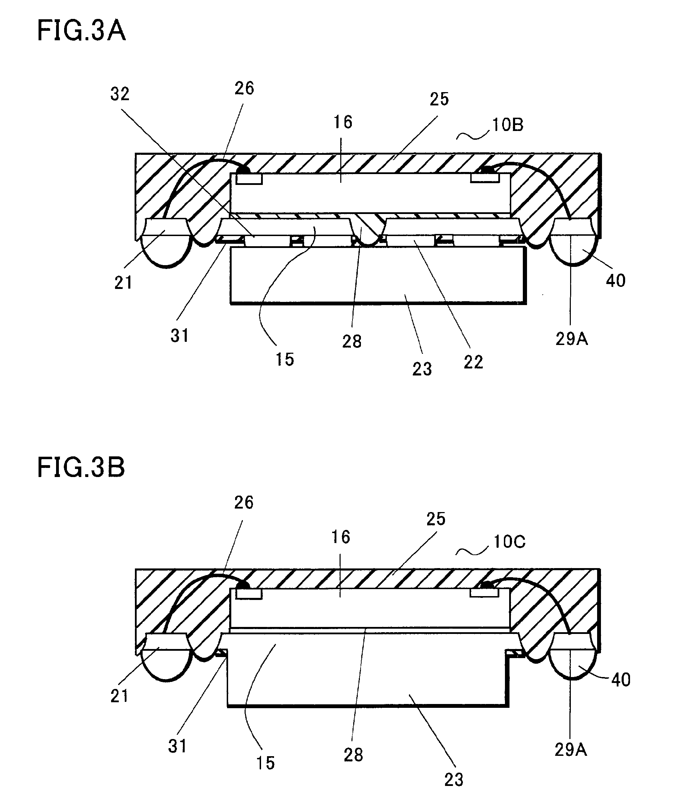

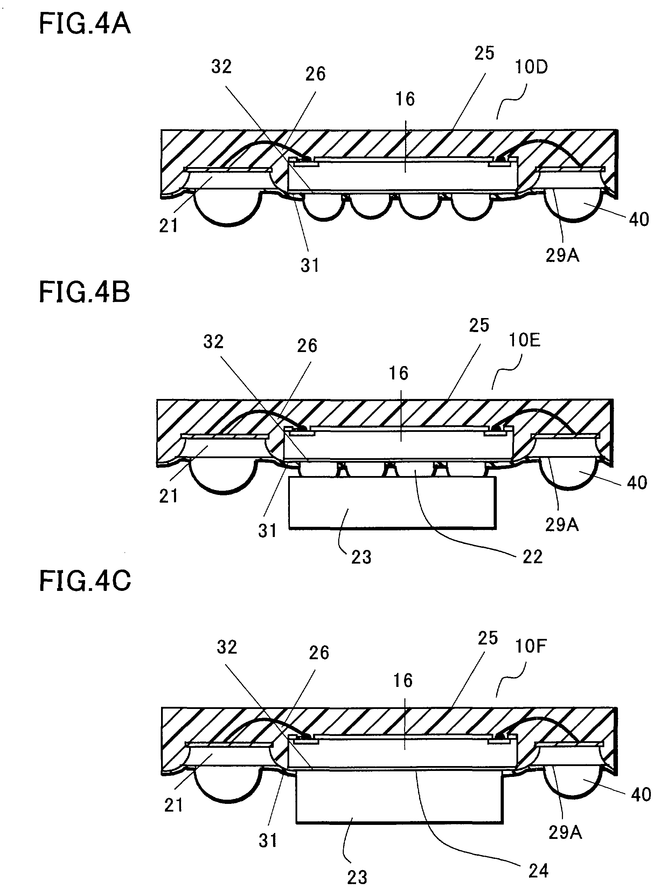

In the semiconductor device 10A shown in FIG.2, bonding pads 21 and an island 15 are arranged substantially on the planar surface and the brazing solder 22 shown herein is directly adhered to the first metal film 14. In the semiconductor device 10B shown in FIG.3A, the metal plate 23 is adhered to the island 15 via the brazing solder 22 and projected from the back surfaces of the bonding pads 21. In the semiconductor device 10C shown in FIG.3B, the island 15 is formed integrally with the metal plate 23 and the back surface of the island 15 is also projected from the back surface of the bonding pads 21. In the semiconductor device 10D shown in FIG.4A, the island 15 is omitted and the back surface of the semiconductor element 16 substantially coincides with the back surfaces of the bonding pads 21. Also, in the semiconductor device 10E shown in FIG.4B, the metal plate 23 is directly adhered to the back surface of the semiconductor element 16 via the brazing solder 22 to project the back surface of the metal plate 23. Finally, in the semiconductor device 10F shown in FIG.4C, the conductive film 24 formed on the back surface of the semiconductor element 16 is directly adhered to the metal plate 23 to project from the back surfaces of the bonding pads 21.

Then, the semiconductor device 10A of the present invention will be explained with reference to FIG.2 hereunder. FIG.2A is a plan view of the semiconductor device and FIG.2B is a sectional view taken along an A-A line.

In FIG.2, following constituent elements are buried into an insulating resin 25. That is, the bonding pads 21..., the island 15 provided in the region surrounded by the bonding pads 21, and the semiconductor element 16 provided on the island 15 are buried. In this case, since the semiconductor element 16 is mounted in a face-up fashion, the bonding electrodes 27 of the semiconductor element 16 are electrically connected to the bonding pads 21 via the metal wires 26.

Also, when the island 15 and the semiconductor element 16 are electrically connected to each other, they are adhered by conductive material. Also, there is no necessity that the island 15 and the semiconductor element 16 are electrically connected to each other, they are adhered via an insulating adhering means . Here, Au is coated on the back surface of the semiconductor element, then Ag is formed on the surface of the island, and then both are adhered to each other by the solder 28.

Also, the back surfaces of the bonding pads 21 are exposed from the insulating resin 25, and act as the external connection electrode 29A as they are. Side surfaces of the bonding pads 21 are etched by the non-anisotropic etching. Here, since the side surfaces of the bonding pads 21 are formed by the wet etching, they have a curved structure and thus the anchor effect is generated by such curved structure.

The present structure consists of the semiconductor element 16, a plurality of conductive patterns 21, 15, the metal wires 26, the fixing means 28 between the semiconductor element and the island 15, and the insulating resin 25 for burying them.

As the fixing means 28, the brazing solder such as solder, the conductive past, the adhesive agent formed of insulating material, the adhesive insulating sheet are preferable.

As the insulating resin 25, thermosetting resin such as epoxy resin, thermoplastic resin such as polyimide resin, polyphenylene sulfide, etc. can be employed.

Also, if the resin is formed by the mould or the resin may be coated by dipping or coating, any resin may be employed as the insulating resin. Also, as the conductive patterns constituting the bonding pads 21 and the island 15, the conductive leaf containing Cu as major material, the conductive leaf foil containing Al as major material, the Fe-Ni alloy, the Al-Cu laminated body, the Al-Cu-Al laminated body, etc. may be employed. Of course, other conductive materials may be employed. In particular, the conductive material that can be etched and the conductive material that can evaporated by the laser are preferable. Also, in light of the half-etching characteristic, the formability by the plating, and the thermal stress, the conductive material containing the rolling-formed Cu as the major material is preferable.

The present invention has such a feature that, since the insulating resin 25 and the adhering means 28 are also filled in a separating groove 30, omission of the conductive pattern can be prevented. Also, the side surfaces of the bonding pads 21...are formed as the curved structure by applying the non-unisotropic etching by employing the dry etching or the wet etching as the etching to generate the anchor effect. As a result, the structure can be achieved in which the conductive patterns 15, 21 do not come out from the insulating resin 25.

In addition, the back surface of the island 15 is exposed from the back surface of the package. Accordingly, the back surface of the island 15 is brought into contact with or is adhered to the metal plate 23 shown in FIG.3A, the second supporting member 13 shown in FIG.1A, or the first metal film 14 coated with the second supporting member 13. According to this structure, the heat generated from the semiconductor element 16 can be radiated and thus the increase in temperature of the semiconductor element 16 can be prevented. As a result, the driving current and the driving frequency of the semiconductor element 16 can be increased.

In the semiconductor device 10A, since the bonding pads 21 and the island 15 are supported by the insulating resin 25 as the sealing resin, the supporting substrate is omitted. This configuration is a feature of the present invention. Since the conduction paths of the semiconductor device in the prior art are supported by the supporting substrate (the flexible sheet, the printed substrate, or the ceramic substrate) or the lead frame, the configurations that may be essentially omitted are added. However, since the present circuit device is constructed by the necessary and lowest minimum constituent elements so as to omit the supporting substrate, the reduction in size and weight can be achieved and also a material cost can be suppressed. Therefore, the semiconductor device 10A becomes inexpensive in cost.

Also, the bonding pad 21 and the island 15 are exposed from the back surface of the package. If the brazing solder such as solder, etc. is coated on this area, the island 15 gets wet in the brazing solder with a different thickness because the island 15 has a wide area. Therefore, in order to make the film thickness of the brazing solder uniform, an insulating film 31 is formed on the back surface of the semiconductor device 10A. A dotted line 32 in FIG.2A indicates an exposed area exposed from the insulating film 31. Here, since the back surfaces of the bonding pads 21 are exposed as a rectangular shape, the same sizes as those shapes are exposed from the insulating film 31.

Accordingly, since the areas wetted by the brazing solder have substantially the same size, the thickness of the brazing solder formed here becomes substantially equal. This is true after the solder print or the solder reflow. It is possible to say that this is true of the conductive paste such as Ag, Au, Ag-Pd, etc. According to this structure, it can be calculated with good precision how much the back surface of the metal plate 23 described later is projected from the back surface of the bonding pads 21. Also, as shown in FIG.2B, if the solder balls 22 are formed, the failure in soldering can be eliminated since bottom ends of all solder balls come into contact with the conduction paths of the mounting board.

Also, the exposed areas 32 of the island 15 may be formed larger than the exposed size of the bonding pads 21 by taking account of the heat radiation of the semiconductor element.

Also, the conductive pattern 33 provided on the first supporting member 11 can be extended to the back surface of the semiconductor device 10A by providing the insulating film 31. In normal, the conductive pattern 33 provided on the first supporting member 11 is arranged to detour the adhering area of the semiconductor device, but such conductive pattern 33 can be arranged without the detour because of formation of the insulating film 31. In addition, since the insulating resin 25 is projected from the conductive pattern, the clearance can be formed between the first supporting member 11 and the wirings and thus merits such as prevention of the short-circuit, facilitation of the cleaning, etc. can be achieved.

### [Fourth embodiment explaining the semiconductor device]

The semiconductor device 10B shown in FIG.3A corresponds the semiconductor device 10B shown in FIG.2 to which the metal plate 23 is adhered. Accordingly, since elements other than the metal plate 23 are substantially similar to FIG.2, different elements will be explained.

A reference 28 is the adhering means, and is projected from the bonding pads 21 and the island 15, as can be seen from the manufacturing method described later. Then, an amount of projection of the back surface of the metal plate 23 can be simply adjusted by a thickness of the metal plate 23. For example, if the metal plate 23 is pushed against the adhering means 28 when the brazing solder 22 is melted, the metal plate 23 can be brought into contact with the back surface of the adhering means 28. Thus, the thickness of the solder between the metal plate 23 and the island 15 can be decided by the projection of the adhering means 28.

Therefore, if the thickness of the metal plate 23 is decided, it can be calculated how long the back surface of the metal plate 23 is projected from the back surface of the external connection electrode 29A (lowermost end of the solder balls 40).

Accordingly, as shown in FIG.1A, if the surface of the radiation substrate 13 is formed lower than the packaging surface of the first supporting member 11, the back surface of the metal plate 23 can be brought into contact with the radiation substrate 13 by forming the radiation substrate 13 after the amount of projection is calculated precisely.

### [Fifth embodiment explaining the semiconductor device]

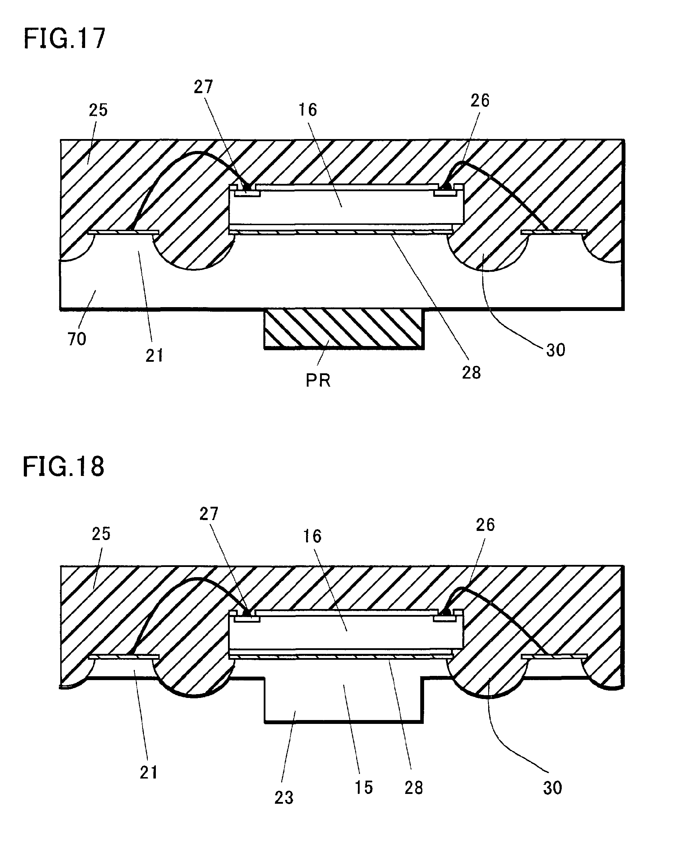

Then, FIG.3B will be explained hereunder. In this semiconductor device 10C, the island 15 and the metal plate 23 are formed integrally. This manufacturing method will be explained later with reference to FIG.17 to FIG.19.

Since the island 15 and the metal plate 23 can be worked from the same conductive leaf by etching, there is no necessity to stick the metal plate 23, unlike FIG.3A. If an amount of etching is controlled, it can be controlled with good precision how long the back surface of the metal plate 23 is projected from the back surface of the external connection electrode 29A (lowermost end of the solder balls 40). Accordingly, like FIG.3A, if the surface of the radiation substrate 13 is formed lower than the packaging surface of the first supporting member 11, the back surface of the metal plate 23 can be brought into contact with the radiation substrate 13 by forming the radiation substrate 13 after the amount of projection is calculated precisely.

### [Sixth embodiment explaining the semiconductor device]

In the semiconductor device 10D shown in FIG.4A, the is land 15 shown in FIG.2, FIG.3 is omitted. If the area acting as the island 15 is also omitted in steps in FIG.13, the back surface of the semiconductor element 16 is exposed from the insulating resin 25, and thus the back surface of the semiconductor element 16 and the back surfaces of the bonding pads 21 are substantially on the same surface level.

In this case, the surface of the semiconductor element 16 can be positioned lower than the surface of the semiconductor element 16 shown in FIG.2, FIG.3. Therefore, this semiconductor device has such a feature that, since the uppermost portions of the metal wires 26 can be positioned at the lower side, the thickness of the insulating resin 25 can be reduced correspondingly and thus the overall size can be formed thin.

Since this semiconductor device is similar to that in FIG.2 except this feature, following explanation will be omitted.

### [Seventh embodiment explaining the semiconductor device]

The semiconductor device 10E in FIG.4B corresponds to the semiconductor device in FIG.4A to which the metal plate 23 is attached. The reason for attaching the metal plate 23 is identical to that in FIG.3A, i.e., to project the back surface of the metal plate 23 from the back surfaces of the bonding pads 21. If the radiation substrate 13 with which the semiconductor device 10E is brought into contact is arranged lower than the bonding pads 21 (or lower ends of the solder balls 40), the semiconductor device 10E can contact to the radiation substrate 13 via the metal plate 23 as the projection.

### [Eighth embodiment explaining the semiconductor device]

The semiconductor device 10F in FIG.4C can be formed by half-etching an area acting as the island 15 and then adhering the back surface of the semiconductor element 16 to the separating groove in the manufacturing method in FIG. 17, and projecting the conductive leaf 70, that is positioned on the back surface of the semiconductor element 16, to the back surface side in steps in FIG.18. If the radiation substrate 13 with which the semiconductor device 10F is brought into contact is arranged lower than the bonding pads 21 (or lower ends of the solder balls 40), the semiconductor device 10F can contact to the radiation substrate 13 via the metal plate 23 as the projection.

The semiconductor device, in which the face up type semiconductor element explained above in FIG.2 to FIG.4C is built, is electrically connected to the conductive pattern 33 on the first supporting member 11 like FIG.1, and also the back surface of the semiconductor device or the metal plate 23, which is formed on the back surface of the semiconductor device, is adhered to the first metal film 14 formed on the second supporting member 13. Especially, since the first metal film 14 consists of the film containing Cu as major material, the film containing Au as major material, and the film containing Ag as major material, the balls 22 made of brazing solder such as solder, etc. can be adhered to the first metal film 14 in FIG.2, FIG.4A and also the metal plate 23can be adhered to the first metal film 14 via the brazing solder or the conductive paste in FIG.3A, FIG.3B, FIG.4B, FIG.4C.

In addition, since the back surface of the semiconductor element 16 is thermally coupled with the radiation substrate 13 as the second supporting member, the heat generated from the semiconductor element can be emitted from the radiation substrate 13 to the metal body 17 constituting an electronic equipment. Thus, the driving ability of the semiconductor element 16 can be improved.

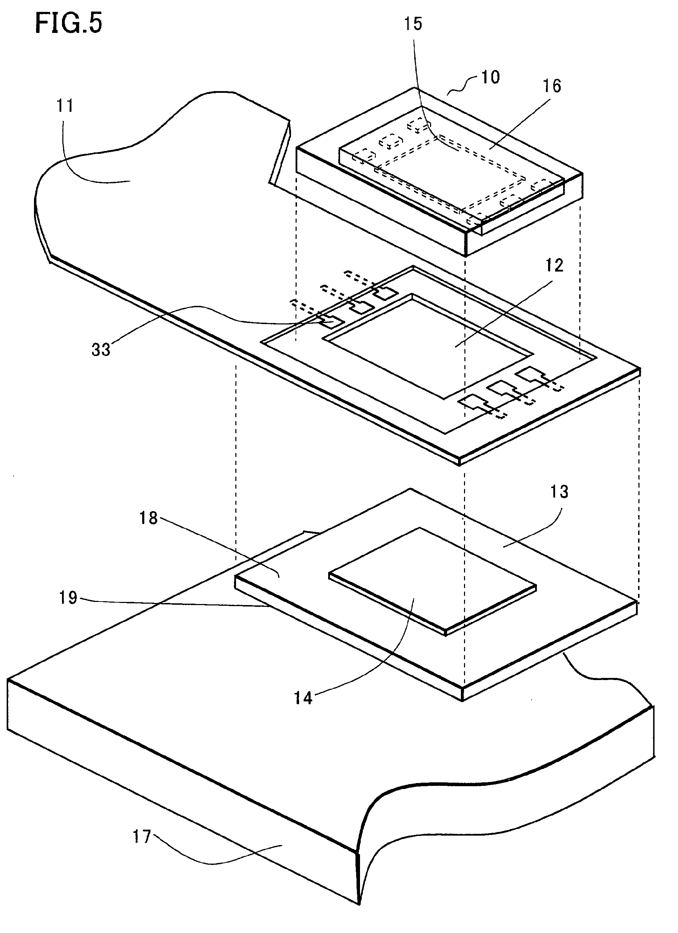

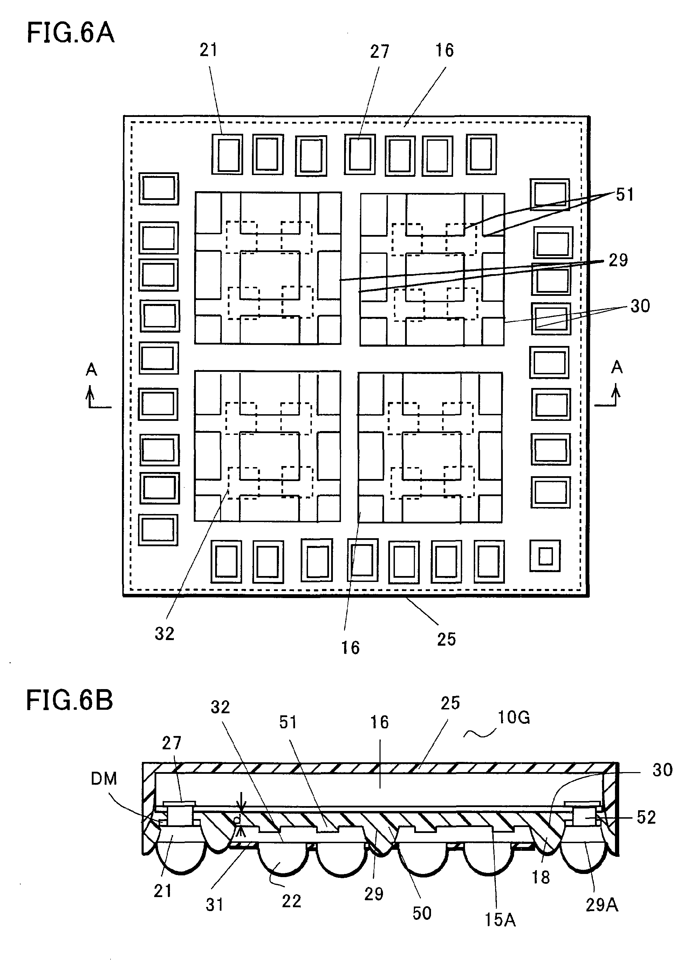

Then, the semiconductor module that is slightly different from the semiconductor module shown in FIG.1 is shown in FIG.5. This module employs the face down semiconductor element shown in FIG.6 to FIG.8. In this case, since the elements except the face down semiconductor element 16 are almost similar, only simple explanation will be give. Also, since the radiation substrate employed as the second supporting member 13 is identical to that in the second embodiment, its explanation will be omitted.

In FIG.5, the semiconductor element 16 is mounted in a face-down fashion and the pads 21 and also the bonding electrodes 27 of the semiconductor element 16 are connected together via the brazing solder such as solder, etc. or bump electrode. Therefore, the thickness of the package becomes thinner than the structure employing the metal wires 26 in FIG.2. But the back surface of the semiconductor element 16 in Fig. 2 is thermally coupled with the island 15 whereas the semiconductor element 16 described herein is inferior in thermal resistance since such semiconductor element 16 is adhered by the insulating adhering means 50. However, this thermal resistance can be reduced by mixing filler into the insulating adhering means 50. In addition, there is such a merit that impedances of the bonding electrodes 27 and the pads 21 can be set lower than the face-up semiconductor element because of the shorter path.

### [Ninth embodiment explaining the semiconductor device]

First, the semiconductor device of the present invention will be explained with reference to FIG. 6. FIG. 6A is a plan view of the semiconductor device, and FIG.6B is a sectional view taken along an A-A line.

In FIG.6, following constituent elements are buried in the insulating resin 25. That is, the pads 21..., the radiation electrode 15A provided in the area surrounded by the pads 21, and the semiconductor element 16 provided on the radiation electrode 15A are buried. In this case, the radiation electrode 15A corresponds to the island 15 in FIG.2. However, since the semiconductor element 16 is mounted in a face-down fashion, it can be adhered to the radiation electrode 15A via the insulating adhering means 50. The radiation electrode 15A is divided into four areas in view of the adhesiveness. A separating groove formed by this four division is indicated by a reference 29. A reference 30 denotes a separating groove formed between the radiation electrodes 15A.

Also, the clearance between the semiconductor element 16 and the radiation electrodes 15A is narrow. Thus, if the insulating adhering means 50 is hard to enter into the clearance, grooves, as indicated by 51, that are shallower in depth than the separating grooves 29, 30 may be formed on the surface of the radiation electrode 15A.

Also, the bonding electrodes 27 of the semiconductor element 16 and the pads 21 are electrically connected to each other via the brazing solder such as solder, etc. Stud bumps such as Au, etc. may be employed in place of the solder. For example, the bumps are provided to the bonding electrodes 27 of the semiconductor element 16 and then the bumps may be connected by the ultrasonic wave or the welding with pressure. Also, reduction in the connection resistance and improvement of the adhering strength may be achieved by providing the solder, the conductive paste, or the anisotropic conductive particles in the peripheries of the pressure-welded bumps.

Also, the back surfaces of the pads 21 are exposed from the insulating resin 25 and acts as the external connection electrode 29A as it is. The side surfaces of the pads 21... are etched by the non-unisotropic etching. Here, the side surfaces have a curved structure since they are formed by the wet etching, the anchor effect is generated by the curved structure.

In the arranging area of the semiconductor element 16, the insulating adhering means 50 is formed on the radiation electrode 15A, or on the pads 21 and between them. Especially, the insulating adhering means 50 is provided in the separating grooves 29 formed by the etching and the back surface of the insulating adhering means is exposed from the back surface of the semiconductor device 10G. Also, all the elements including them are sealed by the insulating resin 25. Then, the pads 21..., the radiation electrode 15A, and the semiconductor element 16 are supported by the insulating resin 25 and the insulating adhering means 50.

The adhesive formed of insulating material, or under-fill material having high osmosis are preferable as the insulating adhering means 50. In the case of the adhesive, such adhesive is coated previously on the surface of the semiconductor element 16 and then semiconductor element 16 is adhered by the pressure welding when the pads 21 are connected by using the Au bumps instead of the solder 52. In the case of the under-fill material, such under-fill material may penetrate into the clearance after the solder 52 (or the bumps) and the pads 21 are connected to each other.

Since the insulating resin and the conductive pattern are similar to the above embodiments, their explanation will be omitted.

In the present invention, like the above embodiment, since the insulating resin 25 and the insulating adhering means 50 are filled in the separating grooves 29, the coming-off of the conductive pattern can be prevented. Also, the side surfaces of the conductive patterns can be formed as the curved structure to generate the anchor effect. As a result, the structure in which the pads 21 and the radiation electrode 15A are not come out from the insulating resin 25 can be implemented.

Also, the back surface of the radiation electrode 15A is exposed from the back surface of the package. Accordingly, the back surface of the radiation electrode 15A can be adhered to the second supporting member 13 or the first metal film 14 on the second supporting member 13 via the solder or the conductive paste. According to this structure, the heat generated from the semiconductor element 16 can be radiated and thus the increase in temperature of the semiconductor element 16 can be prevented. As a result, the driving current and the driving frequency of the semiconductor element 16 can be increased.

Like the above embodiment, the semiconductor device 10G of the present invention does not need the supporting substrate, the reduction in size and weight can be achieved. Thus, the semiconductor device can be packed in the arm or the suspension of the hard disk.

Also, since the exposed areas 32 exposed from the insulating film 31 are set substantially equal in level to the back surfaces of the pads 21, the thickness of the formed brazing solder become substantially equal.

### [Tenth embodiment explaining the semiconductor device 10H]

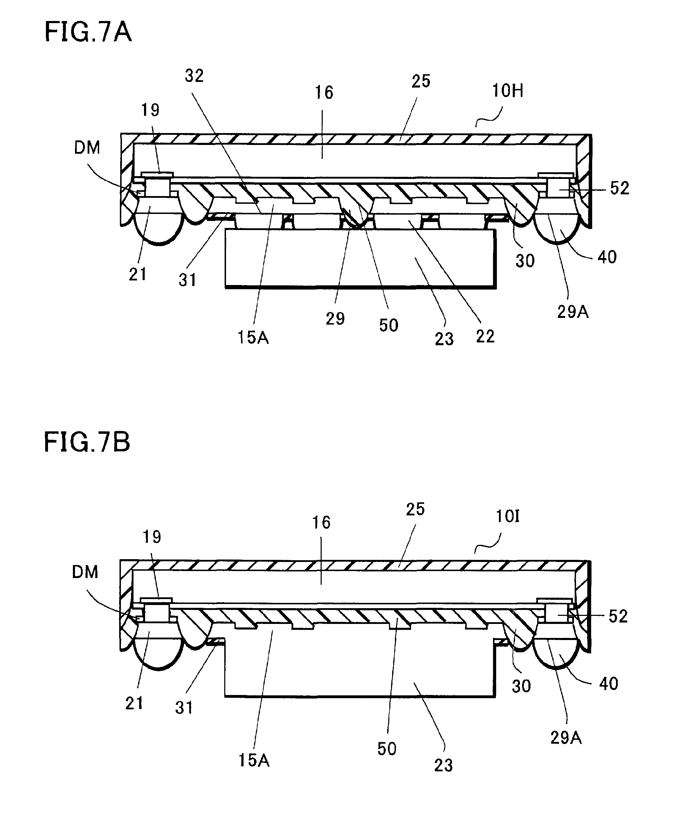

A sectional view of the semiconductor device 10H is shown in FIG.7A. A cutting direction corresponds to an A-A line in FIG.6. In this case, the semiconductor device 10H is constructed by attaching the metal plate 23 to the structure in FIG. 6. Now, different portions will be explained herein.

A reference 50 is the insulating adhering means. As can be seen from the manufacturing method described later, the insulating adhering means is projected from the pads 21 and the radiation electrode 15A. Accordingly, if an amount of projection of the metal plate 23 must be controlled with high precision, the thickness of the solder between the radiation electrode 15A and the metal plate 23 can be maintained constant by pushing the metal plate 23 against the convex portion of the insulating adhering means 50 when the brazing solder 22 is melted.

Accordingly, if the thickness of the metal plate 23 is decided, it can be calculated how long the back surface of the metal plate 23 is projected from the back surface of the external connection electrode 29A (or the lowermost ends of the solder balls 40).

Therefore, as shown in FIG.5, if the surface of the radiation substrate 13 is formed lower than the mounting' surface of the first supporting member 11, the back surface of the metal plate 23 can be brought into contact with the radiation substrate 13 by calculating precisely an amount of downward arrangement.

### [Eleventh embodiment explaining the semiconductor device 10I]

Then, FIG.7B will be explained. In the semiconductor device 10I, the radiation electrode 15A and the metal plate 23 are formed integrally. In this case, the manufacturing method will be described later in FIG.17 to FIG.19.

The radiation electrode 15A and the metal plate 23 are worked from the same conductive leaf by etching. Hence, like FIG.7A, it is possible to eliminate the necessity to stick the metal plate 23 together. If an amount of etching is controlled, it can be controlled with good precision how long the back surface of the metal plate 23 is projected from the back surface of the pads 21 (or lower ends of the solder balls 40). Accordingly, like FIG.7A, if the surface of the radiation substrate 13 is formed lower than the packaging surface of the first supporting member 11, the back surface of the metal plate 23 can be brought into contact with the radiation substrate 13 by forming the radiation substrate 13 after the amount of projection is calculated precisely.

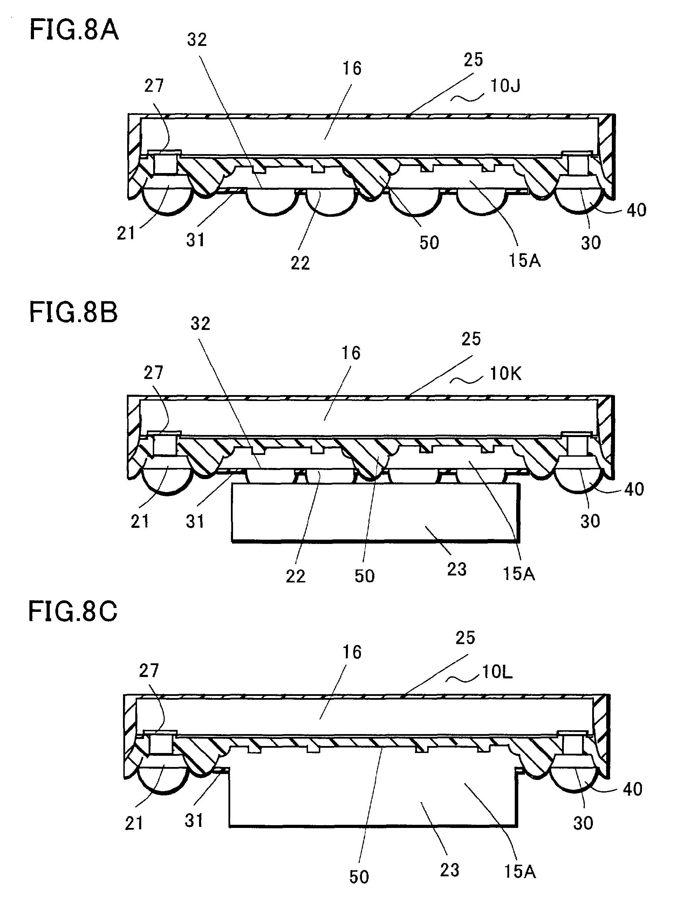

Then, three semiconductor devices shown in FIG.8 will be slightly explained hereunder. Three semiconductor devices 10J to 10L have a structure substantially identical to the semiconductor devices shown in FIG.6 and FIG.7. A difference is that the surface of the radiation electrode 15A is arranged higher than the surfaces of the pads 21. Accordingly, a predetermined interval is provided between the bonding electrodes 27 and the pads 21.

### [Twelfth embodiment explaining the semiconductor device 10J]

The semiconductor device 10J is substantially identical to FIG.6. A difference is that the surface of the radiation electrode 15A is arranged higher than the surfaces of the pads 21. Here, this difference will be explained.

The present invention has such a feature that the surface of the radiation electrode 15A is projected from the surfaces of the pads 21.

As the means for connecting the pads 21 and the bonding electrode 27, there may be considered the Au bump, the solder ball, etc. At least one stage of Au mass is formed as the Au bump, and the thickness of one stage is about 40 µm and thickness of two stages is about 70 to 80 µm. In general, as shown in FIG.6B, since the surface of the radiation electrode 15A and the surfaces of the pads 21 coincide in height with each other, the clearance d between the semiconductor element 16 and the radiation electrode 15A can be substantially decided by the thickness of the bump. Accordingly, in the case of FIG.6B, the clearance d cannot be reduced further more, so that the thermal resistance generated by the clearance cannot be reduced. However, as shown in FIG.8A, if the surface of the radiation electrode 15A is projected rather than the surfaces of the pads 21 to an extent of almost the thickness of the bump, this clearance d can be reduced extremely. Thus, the thermal resistance of the semiconductor element 16 and the radiation electrode 15A can be lowered.

Also, the thickness of the solder bump or the solder ball is about 50 to 70 µm. The clearance d can be reduced in the same way. In addition, since the brazing solder such as the solder has good wettability for the pads, such brazing solder can spread over the entire area of the pads when it is melted, and thus the thickness become thin. However, since the clearance d between the bonding electrode 27 and the pads 21 is decided by the amount of projection of the radiation electrode 15A, the thickness of the brazing solder can be decided by this amount of projection and thus above flow of the solder can be prevented. Accordingly, the stress applied to the solder can be scattered because the thickness of the brazing solder can be formed thick, and thus the degradation due to heat cycle can be suppressed. Also, the cleaning liquid can be entered into this clearance by adjusting this amount of projection.

In FIG.6, in order to prevent the flow of the solder, the flow preventing film DM is formed to control the thickness of the solder. In contrast, in FIG.8, since the flow of the solder can be prevented, such film DM is omitted. However, the flow preventing film DM may be provided.

The projected structure of the radiation electrode 15 is also applied to the semiconductor devices 10K, 10L described in the following.

### [Thirteenth embodiment explaining the semiconductor device 10K]

The semiconductor device 10K shown in FIG.8B is the semiconductor device 10J shown in FIG.8A to which the metal plate 23 is attached. The totally same concept as that in FIG.3A, FIG.7A is applied, wherein the back surface of the metal plate 23 is projected lower than the back surface of the external connection electrode 30 (or the lower ends of the solder balls 40). Accordingly, the back surface of the metal plate 23 can be brought into contact with the radiation substrate 13 shown in FIG.5. The details are given in the explanation in FIG.3A, FIG.7A.

### [Fourteenth embodiment explaining the semiconductor device 10L]

In the semiconductor device 10L shown in FIG.8C, the radiation electrode 15A provide to the semiconductor device 10K shown in FIG.8B and the metal plate 23 are integrally constructed. The totally same concept as that in FIG.3B, FIG.7B is applied, wherein the back surface of the metal plate 23 is projected lower than the back surface of the external connection electrode 30 (or the lower ends of the solder balls 40). Accordingly, the back surface of the metal plate 23 can be brought into contact with the radiation substrate 13 shown in FIG.5. The details are given in the explanation in FIG.3B, FIG.7B.

### [Fifteenth embodiment explaining the semiconductor module]

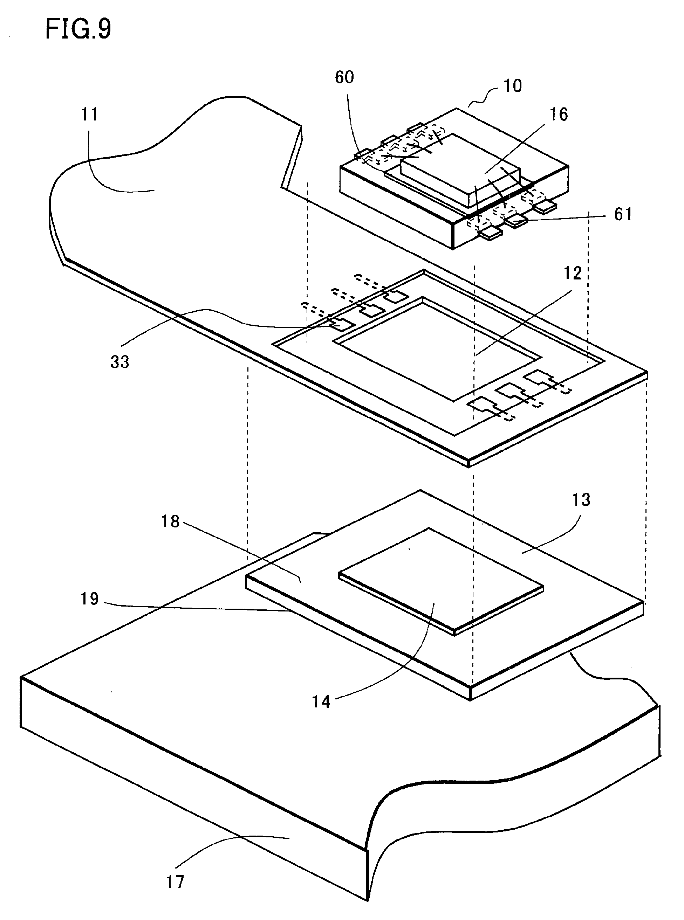

Then, the semiconductor module employing the lead frame as the semiconductor device will be explained by using FIG.9. Since elements other than the semiconductor element are similar to FIG.1, FIG.5, only differences will be explained herein.

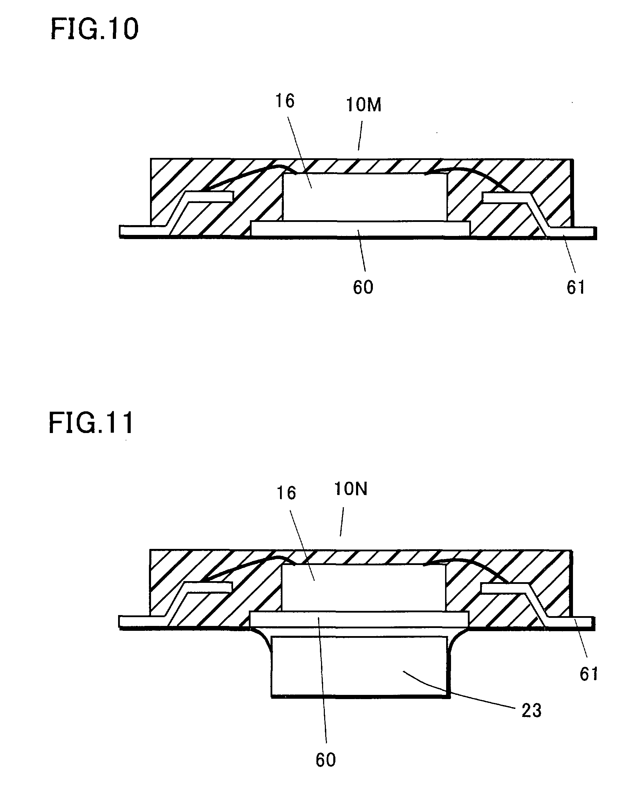

The semiconductor device employed herein are the semiconductor devices 10M, 10N shown in FIG.10, FIG.11.

Leads 61 are arranged around the island 60, then the island 60 and the leads 61 are constructed by lead frames that are supported by the supporting leads called tab lifting lead, or tie bar, then the semiconductor element 16 is mounted, then the wire bonding is applied, then the resultant structure is sealed by the transfer molding, and then the supporting leads are cut off, whereby the semiconductor device can be completed.

In the semiconductor device 10M shown in FIG.10, the back surface of the island 60 and the back surface of the lead 61 are arranged substantially on the same surface level, and at least the back surface of the island 60 is projected from the back surface of the package. Then, the conductive pattern 33 on the flexible sheet 11 and the leads 61, the back surface of the island 60 and the first metal film 14 on the radiation substrate 13 are adhered via the opening portion 12. As the adhering material, the brazing solder such as the solder, etc., the conductive paste, etc. are preferable.

The is land of the semiconductor device 10 may be brought directly into contact with the second supporting member 13 on which the first metal film 14 is not formed.

In contrast, in the semiconductor device 10N shown in FIG.11, the metal plate 23 is adhered to the island 60 and the back surface of the metal plate 23 is projected rather than the back surfaces of the leads 61. Accordingly, if the first metal film 14 is arranged lower than the conductive pattern 33 forming surface, the back surface of the metal plate 23 is projected by the length corresponding to such low arrangement, and the adhesion of the metal plate 23 and the first metal film 14 can be facilitated.

The island of the semiconductor device 10 may be brought directly into contact with the second supporting member 13 on which the first metal film 14 is not formed.

### [Sixteenth embodiment explaining the method of manufacturing a semiconductor device]

The present manufacturing methods are almost identical although slightly different steps are employed depending upon that the semiconductor element is set face- up or face-down.

Here, the manufacturing method will be explained by using the semiconductor device 10A in FIG.2.

First, the conductive leaf 70 is prepared like FIG. 12. It is preferable that the thickness should be set to about 10 to 300 µm, and the rolled copper leaf of 70 µm thickness is employed here. Then, the conductive film 71 or the photoresist is formed on the surface of the conductive leaf 70 as the etching resistance mask. This pattern is the same pattern as the bonding pad 21..., the island 15. If the photoresist is employed in place of the conductive film 71, a conductive film such as Au, Ag, Pd, Ni, or the like is formed in at least the areas corresponding to the bonding pads as the underlying layer of the photoresist. This is provided to enable the bonding (see FIG.12).

Then, the conductive leaf 70 is half-etched via the conductive film 71 or the photoresist. The etching depth may be set shallower than the thickness of the conductive leaf 70. The finer pattern can be formed as the depth of the etching is shallower and shallower.

Then, the bonding pads 21 and the island 15 appears on the conductive leaf 70 like the convex shape by the half etching. As described above, the Cu leaf containing the Cu formed by rolling as the major material is employed as the conductive leaf 70. However, the conductive leaf made of Al, the conductive leaf made of Fe-Ni alloy, the Cu-Al laminated body, the Al-Cu-Al laminated body may be employed. Particularly, the Al-Cu-Al laminated body can prevent the bowing generated due to the difference in the thermal expansion coefficient.

If the radiation electrode should be projected upward as shown in FIG.8, first the area corresponding to the radiation electrode is half-etched, then the radiation electrode is covered with the photoresist, and then the area corresponding to the radiation electrode is half-etched once again (see FIG.13).

The conductive adhering means 28 or the insulating adhering means is provided to the area corresponding to the island 15, then the semiconductor element 16 is adhered, and then the bonding electrodes 27 of the semiconductor element 16 and the bonding pads 21 are electrically connected mutually. In FIG.11, the semiconductor element 16 is mounted in a face-up fashion, the metal wires 26 are employed as the connecting means. Also, in the case of the face down, the solder balls or the bumps are employed (see FIG.14).

Then, the insulating resin 25 is formed to cover the bonding pads 27, the semiconductor element 16, and the metal wires 26. Any of the thermoplastic resin and the thermosetting resin may be employed as the insulating resin.

In the present embodiment, the thickness of the insulating resin is adjusted to cover a height of about 100 µm upward from the top portion of the metal wires 26. This thickness can be increased or decreased in light of the strength of the semiconductor device.

In the resin injection, since the bonding pads 21, the island 15 are formed integrally with the sheet-like conductive leaf 70, positional displacement of the copper leaf patterns are never generated unless the displacement of the conductive leaf 70 is caused. In addition, no resin flash is produced.

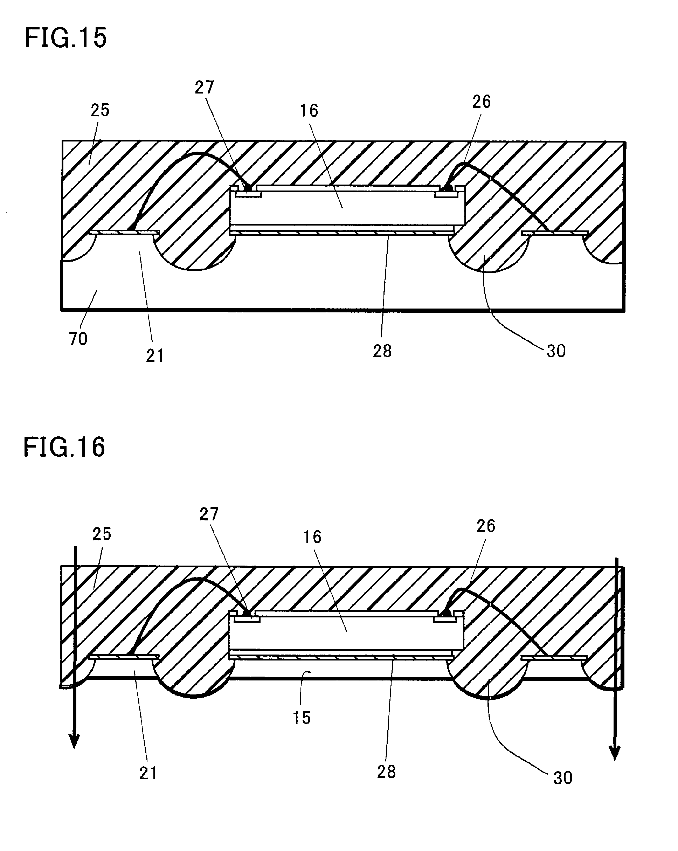

As described above, the bonding pads 21 formed as the convex portions, the island 15, and the semiconductor element 16 are buried into the insulating resin 25, and the conductive leaf 70 located lower than the convex portions is exposed from the back surface (see FIG.15).

Then, the conductive leaf 70 exposed from the back surface of the insulating resin 25 is removed, and the bonding pads 21 and the island 15 are separated individually. Various methods may be considered as this separating step. They may be separated by removing the back surface by the etching, or they may be separated by scraping by virtue of polishing or grinding. Also, both may be employed.

Also, if a plurality of units each consisting of the semiconductor device 10A are formed integrally, the dicing step is added after this separating step.

They are separated individually by employing the dicing device, but the chocolate brake, the press, or the cutting may be employed.

Here, after the Cu pattern is separated, the insulating film 31 is formed on the bonding pads 21 and the island 15 separated and exposed on the back surface, and then the insulating film 31 is patterned to expose the areas indicated by a dotted line in FIG.2A. After this, the module is subjected to the dicing along the lines indicated by an arrow to cut out the semiconductor device 10A.

The solder 22 may be formed before or after the dicing.

According to the above manufacturing method, the small and lightweight package in which the bonding pads and the island are buried in the insulating resin can be accomplished .

Then, the method of manufacturing the semiconductor device in which the metal plate 23 and the island 15 are formed integrally will be explained with reference to FIG.17 to FIG. 19 hereunder. Since the similar steps may be employed up to FIG. 15, the explanation made up to there will be omitted.

FIG.15 shows the state in which the insulating resin 25 is coated on the conductive leaf 70, wherein the photoresist PR is covered on the area corresponding to the island 15. If the conductive leaf 70 is etched via the photoresist PR, the island 15 can be projected from the back surfaces of the bonding pads 21, as shown in FIG.18. The conductive film such as Ag, Au, etc. is selectively formed in place of the photoresist PR, and then may be used as a mask. This film can also act as the oxidation preventing film.

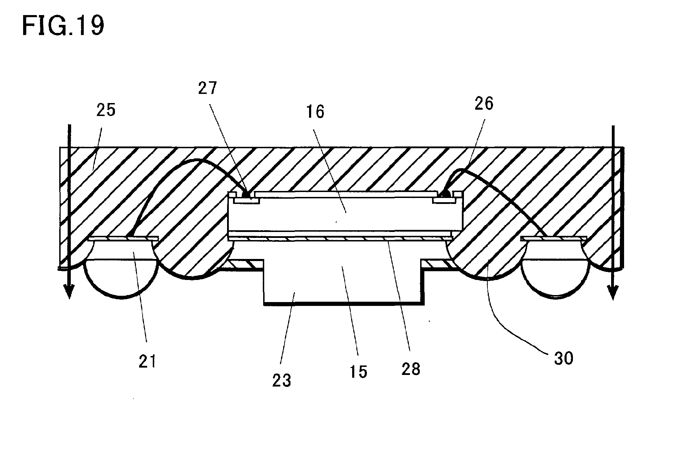

Then, as shown in FIG.19, after the bonding pads 21 and the island 15 are perfectly separated, the insulating film 31 is coated, and then the areas at which the brazing solder 22 is arranged are exposed. Then, the brazing solder 22 is adhered and then the module is separated by the dicing.

The semiconductor device separated in this manner is mounted on the first supporting member 11, as shown in FIG.1. As described above, since the island 15 is projected, it can be jointed simply to the first metal film 14 via the solder, etc.

In the semiconductor device explained in above all embodiments, the size of the island 15 (or the radiation electrode) may be reduced, the wirings formed integrally with the bonding pads 21 (or pads) may be extended to the back surface of the semiconductor element 16, and new external connecting electrodes may be provided there. This pattern is provided based on the same concept as the rewiring used in BGA, etc. There is such a merit that the stress in respective connecting portions can be relaxed by the rewiring. Also, since the wirings and the external connecting electrodes are provided on the back surface of the semiconductor element, the insulating adhering means 50 must be formed of insulating material. Also, the back surface of the rewiring is covered with the insulating film 31.

As apparent from the above explanation, the radiation substrate of the present invention has excellent heat radiating characteristic by forming the first metal film containing Cu, Ag, Sn, Ni, or Au as the major material on the radiation substrate containing Al as the major component.

Since the growth of the oxide film is small on the radiation substrate containing Al as the major material, the generation of particles is small correspondingly, and also the malfunction of the electronic equipment mounted in the inside can be reduced. In addition, the first metal film containing Cu, Ag, Sn, Ni or Au as the major material can be formed on the surface of Al, and also the metal body (e.g., the island or the radiation electrode) exposed from the back surface of the semiconductor device can be thermally coupled with the first metal film via the conductive adhering material. Accordingly, such radiation substrate can serve as the radiation substrate that generates a small amount of particles and has excellent thermal conduction.

Also, the first metal film can be formed by the plating, and the radiation substrate having small thermal resistance can be implemented.

Also, since the semiconductor device in which the metal plate is adhered to the metal body exposed to the back surface of the package and the metal plate is projected rather than the back surfaces of the external connecting electrodes or the pads can be provided, there is such a merit that packaging into the FCA can be facilitated.

Also, since the opening portion is provided to the FCA and the back surface of the FCA and the radiation electrode of the semiconductor device are positioned on the same surface level, the contact to the second supporting member can be facilitated.

Also, since Al is used as the second supporting member, and the first metal film made of Cu is formed there, and the radiation electrode or the metal plate can be adhered to the metal film, the heat generated from the semiconductor element can be radiated to the outside via the second supporting member.

Therefore, the temperature increase of the semiconductor element can be prevented, and thus the performance close to the natural ability can be extracted. In particular, since the FCA mounted in the hard disk can emit the heat to the outside effectively, the reading/ writing speed of the hard disk can be increased.

## Claims

1. A radiation substrate having a first surface and a second surface, both opposed to each other, and containing Al as a major component,
wherein a first metal film containing Cu, Ag, Sn, Ni, or Au as major material is formed as an uppermost layer on the first surface.

2. A radiation substrate according to claim 1, wherein the first metal film consists of a plating film.

3. A radiation substrate according to claim 2, wherein a metal body provided on a back surface of a semiconductor device is adhered by brazing solder, conductive paste, or adhering material having excellent thermal conductivity.

4. A radiation substrate according to claim 3, wherein the semiconductor device is mounted to be connected electrically to an electronic equipment, and the second surface is worked such that it can be connected to a constituent element made of metal in the electronic equipment via surface contact.

5. A semiconductor module comprising:
a semiconductor device in which a face up semiconductor element is sealed integrally by insulating resin and also pads connected electrically to bonding electrodes of the semiconductor element and an island positioned on a back surface of the semiconductor element are exposed from the back surface; and
a radiation substrate having a first surface and a second surface, both opposed to each other, and containing Al as a major component;
wherein a first metal film containing Cu, Ag, Sn, Ni, or Au as major material and formed by plating is formed as an uppermost layer on the first surface, and
the first metal film and the island are adhered together by brazing solder, conductive paste, or adhering material having excellent thermal conductivity.

6. A semiconductor module according to claim 5, wherein a metal film containing Cu as a major component is adhered between the first metal film and the island.

7. A semiconductor module according to claim 6, wherein the island and the metal plate are formed integrally by the etching process.

8. A semiconductor module according to claim 5, wherein a back surface of the semiconductor element is adhered to the metal plate.

9. A semiconductor module according to claim 5, wherein back surfaces of the pads and a back surface of the island are arranged substantially on a same planar surface.

10. A semiconductor module according to claim 8, wherein back surfaces of the pads and a back surface of the semiconductor element are arranged substantially on a same planar surface.

11. A semiconductor module according to claim 9 or claim 10, wherein a back surface of the insulating resin is projected rather than back surfaces of the pads.

12. A semiconductor module according to claim 11, wherein side surfaces of the pads and a back surface of the insulating resin extended from the side surfaces of the pads draw a same curved surface.

13. A semiconductor module according to claim 12, wherein a flexible sheet having conductive patterns connected electrically to the semiconductor device is provided between the semiconductor device and the radiation substrate, and an opening portion is provided in the flexible sheet to respond ' to the island.

14. A semiconductor module comprising:
a semiconductor device in which a face down semiconductor element is sealed integrally by insulating resin and also pads connected electrically to bonding electrodes of the semiconductor element and a radiation electrode positioned on a back surface of the semiconductor element are exposed from the back surface; and
a radiation substrate having a first surface and a second surface, both opposed to each other, and containing Al as a major component;
wherein a first metal film containing Cu, Ag, Sn, Ni, or Au as major material and formed by plating is formed as an uppermost layer on the first surface, and
the first metal film and the radiation electrode are adhered together by brazing solder, conductive paste, or adhering material having excellent thermal conductivity.

15. A semiconductor module according to claim 14, wherein a metal film containing Cu as a major component is adhered between the first metal film and the radiation electrode.

16. A semiconductor module according to claim 14, wherein the radiation electrode and the metal plate are formed integrally by the etching process.

17. A semiconductor module according to claim 14, wherein back surfaces of the pads and a back surface of the radiation electrode are arranged substantially on a same planar surface.

18. A semiconductor module according to claim 17, wherein a back surface of the insulating resin is projected rather than back surfaces of the pads.

19. A semiconductor module according to claim 18, wherein side surfaces of the pads and a back surface of the insulating resin extended from the side surfaces of the pads draw a same curved surface.

20. A semiconductor module according to claim 19, wherein a flexible sheet having conductive patterns connected electrically to the semiconductor device is provided between the semiconductor device and the radiation substrate, and an opening portion is provided in the flexible sheet to respond to the radiation electrode.

21. A semiconductor module comprising:
a semiconductor device in which a face up semiconductor element is sealed integrally by insulating resin and also leads connected electrically to bonding electrodes of the semiconductor element and an island whose back surface is positioned on a same surface level as a back surface of the leads are exposed from the back surface; and
a radiation substrate having a first surface and a second surface, both opposed to each other, and containing Al as a major component;
wherein a first metal film containing Cu, Ag, Sn, Ni, or Au as major material and formed by plating is formed as an uppermost layer on the first surface, and
the first metal film and the island are adhered together by brazing solder, conductive paste, or adhering material having excellent thermal conductivity.

22. A semiconductor module according to claim 21, wherein a metal film containing Cu as a major component is adhered between the first metal film and the island.

23. A semiconductor module according to claim 22, wherein a flexible sheet having conductive patterns connected electrically to the semiconductor device is provided between the semiconductor device and the radiation substrate, and an opening portion is provided in the flexible sheet to respond ' to the island.

24. A semiconductor module according to claim 13, claim 20 or claim 23, wherein the semiconductor device is a read/write amplifier IC for a hard disk.

25. A semiconductor module according to claim 13, claim 20 or claim 23, wherein the semiconductor device is mounted to be connected electrically to an electronic equipment, and the second surface is worked such that it can be connected to a constituent element made of metal in the electronic equipment via surface contact.

26. A hard disk drive comprising a radiation substrate claimed in any one of claims 1 to 4.

27. A hard disk drive comprising a semiconductor module claimed in any one of claims 5 to 25.

28. A hard disk drive comprising:
a recording disk;
a spindle motor which rotates said recording disk;
a magnetic head for writing and reading signals to and from said recording disk;
a suspension arm for supporting said magnetic head;'
an actuator for controlling a position of said magnetic disk;
an semiconductor module for processing said signals; and
a casing for accommodating said recording disk, said spindle motor, said suspension arm, and semiconductor module,
wherein said semiconductor module comprising:
a semiconductor device in which a face up semiconductor element is sealed integrally by insulating resin and also pads connected electrically to bonding electrodes of the semiconductor element and an island positioned on a back surface of the semiconductor element are exposed from the back surface; and
a radiation substrate having a first surface and a second surface, both opposed to each other, and containing Al as a major component;
wherein a first metal film containing Cu, Ag, Sn, Ni, or Au as major material and formed by plating is formed as an uppermost layer on the first surface, and
the first metal film and the island are adhered together by brazing solder, conductive paste, or adhering material having excellent thermal conductivity.

29. A hard disk drive comprising:
a recording disk;
a spindle motor which rotates said recording disk;
a magnetic head for writing and reading signals to and from said recording disk;
a suspension arm for supporting said magnetic head;
an actuator for controlling a position of said magnetic disk;
an semiconductor module for processing said signals;
a casing for accommodating said recording disk, said spindlemotor, saidsuspensionarm, and semiconductor module; and
a radiation substrate for radiating heat generated in the casing, said radiation substrate having a first surface and a second surface, both opposed to each other, and containing Al as a major component,
wherein a first metal film containing Cu, Ag, Sn, Ni, or Au as major material is formed as an uppermost layer on the first surface.
